Europäisches Patentamt

European Patent Office

Office européen des brevets

(11) Veröffentlichungsnummer: **0 315 774**
**A2**

(12) # EUROPÄISCHE PATENTANMELDUNG

(21) Anmeldenummer: **88116517.9**

(22) Anmeldetag: **06.10.88**

(51) Int. Cl.4: **G03F 1/00 , G03F 5/00 , G03C 5/36**

(30) Priorität: **29.10.87 DE 3736645**

(43) Veröffentlichungstag der Anmeldung:
**17.05.89 Patentblatt 89/20**

(84) Benannte Vertragsstaaten:
**BE CH DE ES FR GB IT LI NL**

(71) Anmelder: **DU PONT DE NEMOURS (DEUTSCHLAND) GMBH**
**Du Pont Strasse 1**
**D-6380 Bad Homburg(DE)**

(72) Erfinder: **Rüger, Reinhold, Dr.**
**Schillerstrasse 11**
**D-6074 Rödermark(DE)**

(54) **System zur Herstellung punktgeätzter lithographischer Filme.**

(57) Die vorliegende Erfindung betrifft ein System zur Herstellung punktgeätzter lithographischer Filme, bestehend aus einem lichtempfindlichen Silberhalogenidmaterial für die Gerbentwicklung und einer Ätzlösung, wobei das lichtempfindliche, verschiedene Schichten aufweisende Material Pigmente oder Farbstoffe mit sauren Gruppen enthält, die beständig gegenüber den Verarbeitungsbädern sind und mit Basen in organischen Lösungsmitteln lösliche Salze bilden, und die Ätzlösung eine das Pigment oder den Farbstoff ionisierende Base und ein Lösungsmittel für das gebildete Ionenpaar enthält.

EP 0 315 774 A2

## System zur Herstellung punktgeätzter lithographischer Filme

Die vorliegende Erfindung betrifft ein System zur Herstellung punktgeätzter lithographischer Filme, bestehend aus einem lichtempfindlichen Material für die Gerbentwicklung und einer Ätzlösung, wobei das lichtempfindliche Material, bestehend aus einem Schichtträger, mindestens einer pigment- oder farbstoffhaltigen, gelatinehaltigen Schicht, einer unmittelbar über dieser Schicht angeordneten gerbbaren, gelatinehaltigen Deckschicht, gegebenenfalls weiteren Hilfsschichten und lichtempfindlichem Silberhalogenid, enthalten in der pigment- oder farbstoffhaltigen Schicht und/oder der Deckschicht, nach der bildmäßigen Belichtung, der Entwicklung und dem Entfernen der unbelichteten Bereiche zur Verkleinerung der Rasterpunkte mit der Ätzlösung behandelt wird. Das Anwendungsgebiet der Erfindung ist die Reprographie, insbesondere im Bereich der Herstellung von Farbauszügen und Kontaktkopien.

Auf dem photographischen Reproduktionssektor finden bekanntlich Photomasken, die für aktinische Strahlung undurchlässige Bildbereiche enthalten, als Vorlagen bei der bildmäßigen Belichtung von lichtempfindlichen Materialien Verwendung, z.B. für die Herstellung von Farbauszügen, Druckplatten, usw.

Zur Herstellung von gerasterten Photomasken, bei denen das Bild aus Punkten unterschiedlicher Größe aufgebaut ist, werden als "Lithofilme" bezeichnete Silberhalogenidfilme verwendet. Es ist nun häufig erforderlich, die Tonwerte des entwickelten Silberbildes nachträglich zu korrigieren. Hierzu werden in einem Punktätzungsprozeß die Rasterpunkte verkleinert, indem das in den belichteten Bildbereichen vorhandene Silber oxidativ mit Silberlösungsmittel teilweise entfernt wird.

Ein Nachteil der beschriebenen Silberhalogenidfilme ist ihr hoher Silberauftrag, und damit ihr hoher Herstellungspreis.

Es ist bekannt, daß belichtete photographische Materialien, die eine nicht oder nur wenig gehärtete, gelatinehaltige Silberhalogenidemulsionsschicht enthalten, durch Behandlung mit gerbenden Entwicklersubstanzen bildmäßig gehärtet werden können. Die an den belichteten Bildstellen bei der Entwicklung entstehenden Oxidationsprodukte der gerbenden Entwickler besitzen nämlich die Eigenschaft, Gelatine zu härten.

An den unbelichteten Bildstellen, wo keine Entwicklung stattfindet, unterbleibt dagegen die Härtung, und diese Bildstellen können daher mit warmem Wasser unter Bildung von Reliefbildern ausgewaschen oder ganz oder teilweise auf ein Bildempfangsmaterial übertragen werden. Es ist bekannt, dem lichtempfindlichen Material Pigmente oder Farbstoffe, insbesondere. Ruß, zuzusetzen, um den Bildbereichen eine ausreichende optische Dichte zu verleihen. Hierdurch wird eine Reduzierung der zur Bilderzeugung notwendigen Silberhalogenidmenge ermöglicht. Die beschriebenen Auswaschfilme sind zum Beispiel in den folgenden Patentschriften und -anmeldungen beschrieben: US 3,364,024, US 3,440,049, GB 1,294,355, US 2,596,756, US 4,369,245, DE 28 32 530, EP 01 06 464 und EP 01 05 109.

Ein großer Nachteil der Auswaschfilme für gerbende Entwicklung gegenüber Silberhalogenidfilmen ist ihre fehlende Naßätzbarkeit, wodurch ihre Anwendung im reprographischen Bereich erheblich eingeschränkt wird. Dies gilt besonders bei der Herstellung und Reproduktion von Farbauszügen für den Mehrfarbendruck.

Dieses Problem sollte prinzipiell durch die Verwendung von Materialien mit kolloidalem Silber als bildaufbauendes Pigment, wie sie z.B. in der europäischen Patentanmeldung EP 01 95 327 beschrieben sind, lösbar sein, da solche Filme nach den herkömmlichen Methoden ätzbar sein sollten. Gegenüber dieser Lösung gibt es jedoch schwerwiegende verarbeitungstechnische Vorbehalte, da beim Auswaschen ungehärteter Filmbereiche das Silber in das Waschwasser gelangt, dessen Aufbereitung dann mit großem technischen und finanziellen Aufwand verbunden wäre. Als weiterer Nachteil sind noch die höheren Kosten des Filmmaterials zu nennen, die durch den hohen Preis des Silberpigments gegenüber anderen Pigmenten entstehen.

Zahlreiche andere Pigmente und Farbstoffe kommen dagegen deshalb nicht in Frage, weil durch sie die Bildaufzeichnung des Silberhalogenids bzw. der Gerbprozeß behindert wird. Verbindungen, die zur Kristallisation in der Schicht oder zum "Ausblühen" neigen, sind als Pigmente oder Farbstoffe auch ungeeignet. Das gleiche gilt für Stoffe die unter Einwirkung der Verarbeitungsbäder entfärbt oder aus der Schicht heraus gelöst werden. Nach der Verarbeitung sollen die Pigmente oder Farbstoffe aber auf Wunsch entfärbt oder teilweise aus dem Film entfernt werden können, um eine Verkleinerung der Rasterpunkte zu erreichen. Gewünscht ist vor allem eine Rasterpunktverkleinerung ohne eine Verringerung ihrer optischen Dichte. Außerdem sollte die mechanische Stabilität des Filmmaterials erhalten bleiben, und der Film durch die herausgelösten Pigmente oder Farbstoffe nicht eingefärbt werden.

Aufgabe der vorliegenden Erfindung ist es daher, eine Möglichkeit zur Herstellung punktgeätzter lithographischer Filme anzugeben, die andere Pigmente als Silber enthalten, und wobei die systembedingten Vorteile der Auswaschfilme, wie der niedrige Silberauftrag und die schnelle, automatische Verarbeitung, nicht beeinträchtigt werden.

Diese Aufgabe wird gelöst durch ein System zur Herstellung von punktgeätzten lithographischen Filmen, bestehend aus einem lichtempfindlichen Material für die Gerbentwicklung und einer Ätzlösung, wobei das lichtempfindliche Material, bestehend aus einem Schichtträger, mindestens einer pigment- oder farbstoffhaltigen, gelatinehaltigen Schicht, einer unmittelbar über dieser Schicht angeordneten, gerbbaren, gelatinehaltigen Deckschicht, gegebenenfalls weiteren Hilfsschichten und lichtempfindlichem Silberhalogenid, enthalten in der pigment- oder farbstoffhaltigen Schicht und/oder der Deckschicht, nach der bildmäßigen Belichtung, der Entwicklung und dem Entfernen der unbelichteten Bereiche zur Verkleinerung der Rasterpunkte mit der Ätzlösung behandelt wird.

Die Erfindung ist dadurch gekennzeichnet, daß die verwendeten Pigmente oder Farbstoffe mindestens eine saure Gruppe enthalten, beständig gegenüber den Verarbeitungsbädern sind und mit Basen in organischen Lösungsmitteln lösliche Salze bilden, und die verwendete Ätzlösung mindestens eine das Pigment oder den Farbstoff ionisierende Base und mindestens ein organisches Lösungsmittel für die gebildeten Ionenpaare enthält.

Pigmente oder Farbstoffe im Sinne der Erfindung zeichnen sich dadurch aus, daß sie mindestens eine saure Gruppe enthalten, beständig gegenüber den Verarbeitungsbädern sind und mit Basen in organischen Lösungsmitteln lösliche Salze bilden. Vorzugsweise sollte ihr pks-Wert zwischen 10 und 14 liegen. Typische Beispiele für solche Gruppen sind phenolisch gebundene Hydroxygruppen, bevorzugt in $\alpha$-Stellung zu einer Azogruppe, und enolisch gebundene Hydroxygruppen, wie in Derivaten der Acetessigsäure. Zu den besonders bevorzugten Verbindungen dieser Art gehören Pigment Rot 3 (C.I. 12120), Pigment Rot 112 (C.I. 12370), Pigment Gelb 74 (C.I. 11741), Orange 5 (C.I. 12075) und Sudan-Orange 220 (C.I. 12055).

Die Pigmente oder Farbstoffe sind vor der Verarbeitung im Film vorhanden. Sie werden als wäßrige Dispersion der Silberhalogenidemulsion zugesetzt und zusammen mit allen anderen Bestandteilen aufgetragen. Die Teilchengröße der Pigmente oder Farbstoffe sollte unterhalb der Schichtdicke der Pigmentschicht liegen, vorzugsweise im Submikrobereich von 0,2 - 1 $\mu$.

Die pigment- oder farbstoffhaltige Schicht kann darüberhinaus Füllstoffe oder andere Zusatzstoffe enthalten. Das Pigment kann mit Gieß-oder Dispergiermitteln vorbehandelt sein. Das Verhältnis Pigment/Bindemittel kann zwischen 3 : 1 bis 1 : 10 liegen, bevorzugt wird der Bereich zwischen 2 : 1 und 1 : 3.

Wesentlich für das erfindungsgemäße System zur Herstellung punktgeätzter lithographischer Filme ist die Anwesenheit einer Deckschicht über der pigment- oder farbstoffhaltigen Schicht. Diese Decksschicht besteht im wesentlichen, im einfachsten Fall ausschließlich, aus Gelatine. Durch die Gerbaktion bleibt diese Schicht bildmäßig erhalten und hemmt den Angriff der Ätzlösung von oben, wodurch der Angriff an der Punktflanke und damit die Punktverkleinerung begünstigt wird und die optische Dichte erhalten bleibt. Der Trockenauftrag dieser Schicht kann zwischen 0.3 und 1.5 g Gelatine/m² liegen. Außerdem können Zusatzstoffe eingearbeitet werden, wie Polyethylenwachse, Kieselsäure etc. Zur Verminderung der Quellbarkeit kann diese Schicht eine geringe Menge Härter (z.B. Chromalaun) enthalten.

Die einfachste Ausführungsform eines für das erfindungsgemäße System geeigneten Films ist der Zweischichtaufbau mit einer Pigmentschicht auf dem Träger und einer Deckschicht über der pigmentierten Schicht. Es werden aber Filmstrukturen bevorzugt, die neben den oben genannten Schichten noch weitere Hilfsschichten enthalten, z.B. einen weiteren Überguß. Die lichtempfindliche Emulsion kann wahlweise in einer oder in mehreren Schichten enthalten sein. Als Silberhalogenide kommen Silberchlorid, Silberbromid oder ihre Mischungen vor allem auch mit Silberjodid in Frage. Die lichtempfindliche Emulsion kann chemisch und/oder spektral sensibilisiert sein durch jeden Sensibilisator oder jede Sensibilisierungstechnik. Andere Zusätze wie Antischleiermittel, Netzmittel etc. können ebenfalls in der Emulsion vorhanden sein.

Zur Bilderzeugung geeignete Gerbentwicklersubstanzen sind aus der Literatur in großer Zahl bekannt. In diesem Zusammenhang seien genannt die Polyoxyverbindungen des Benzols, Naphthalins oder Diphenyls, die durch Halogen- oder Alkyl- beziehungsweise Arylgruppen am Kern substituiert sein können. Besonders geeignet sind die in der Patentschrift US 3,440,049 beschriebenen Polyhydroxy-spiro-bis-indan-Verbindungen. Die Gerbentwicklersubstanzen können einer oder mehreren Schichten des lichtempfindlichen Materials zugesetzt werden, sie können aber auch in den Behandlungsbädern vorhanden sein. Nach einer besonders bevorzugten Ausführungsform enthält das lichtempfindliche Material die Gerbentwicklersubstanz in einem zusätzlichen Überguß.

Als Träger in einem für das erfindungsgemäße System geeigneten Film kommen die für diesen Zweck bekannten transparenten oder opaken Materialien in Frage. Genannt seien insbesondere Papiere, Glas, Folien oder Faservliese aus natürliche oder synthetischen Polymeren.

3

Zur Herstellung des Bildes wird das photographische Material durch eine Vorlage belichtet, entwickelt und anschließend bildmäßig ausgewaschen. Ist die Gerbentwicklersubstanz ganz oder überwiegend in der Entwicklerlösung enthalten, können die bekannten Gerbentwicklerlösungen, die neben der Gerbentwicklersubstanz als wesentlichen Bestandteil ein Alkali, beziehungsweise ein Alkaligemisch enthalten verwendet werden.

Die Bäder können selbstverständlich noch andere bekannte Zusätze, wie zum Beispiel Netzmittel, sequestrierende Verbindungen und Oxidationsschutzmittel, enthalten. Ist die Entwicklersubstanz in der photographischen Schicht enthalten, so erfolgt die Entwicklung mit einem alkalischen Aktivatorbad. Geeignete Alkalien zur Herstellung solcher Aktivatorlösungen sind Alkalicarbonate und Alkalihydroxide, sowie die bekannten Carbonat- und Phosphat-Puffersysteme. Das Auswaschen der nicht gehärteten Bildteile erfolgt bevorzugt durch Aufsprühen von warmem Wasser von mindestens 30° C.

Die für das erfindungsgemäße System geeignete Ätzlösung besteht im wesentlichen aus mindestens einem polaren, mit Wasser mischbaren Lösungsmittel oder Lösungsmittelgemisch, einer starken Base und Wasser. Die Zusammensetzung der Ätzlösung richtet sich nach dem verwendeten Pigment oder Farbstoff. Das Lösungsmittel oder Lösungsmittelgemisch kann aus Stoffen wie Alkohole, Ether, Lactone, Ketone, usw. bestehen. Als besonders effektiv im Sinne der Erfindung hat sich ein Gemisch aus Ethanol und Aceton erwiesen. Als Base wird bevorzugt ein Alkalihydroxid, insbesondere Kaliumhydroxid, genommen, aber auch die Anwendung anderer Basen ist möglich.

Über die Zusammensetzung der Ätzlösung läßt sich die Ätzgeschwindigkeit steuern. Sie kann zum Beispiel durch die Vergrößerung des Basenanteils oder des Alkoholgehalts erhöht werden.

Der Ätzvorgang erfolgt in bekannter Weise durch Eintauchen des Filmmaterials in die Ätzlösung bei Raumtemperatur oder durch Aufpinseln der Lösung. Der Vorgang wird durch Abspülen des Films mit Wasser gestoppt. Dieser Ätzvorgang läßt sich mehrfach wiederholen. Aus gebrauchten Ätzlösungen können die mit Wasser aus dem Film herausgelösten Pigmente oder Farbstoffe durch Verdünnen oder Ansäuern abgeschieden werden.

Das erfindungsgemäße System kombiniert in idealer Weise die Vorteile von Auswaschfilmen für gerbende Entwicklung und konventionellen Silbersalzfilmen. Mit ihm ist es möglich, Rasterpunkte an Auswaschfilmen für die Gerbentwicklung nach der Verarbeitung abzuschwächen, ohne die Vorteile solcher Auswaschfilme wie geringer Silberauftrag, schnelle Verarbeitung, etc. zu beeinträchtigen. Es wird eine Punktverkleinerung erreicht, ohne daß die optische Dichte verringert wird. Außerdem wird die mechanische Stabilität des Filmmaterials während und nach der Behandlung nicht beeinträchtigt.

Die Erfindung wird durch die folgenden Beispiele näher erläutert, ohne jedoch darauf beschränkt zu sein.

Beispiel 1

Für die Herstellung der lichtempfindlichen Materialien für die gerbende Entwicklung wurden die folgenden Gießlösungen hergestellt:

Gließlösungen I a-e

Eine chemisch gereifte Silberchloridemulsion vom Lippmann-Typ, die 160 g Gelatine pro Mol Ag enthielt, wurde mit einer wäßrigen Pigmentdispersion, die jeweils eines der folgenden Pigmente enthielt

    a) Orange 5 C.I. 12075
    b) Pigmentrot 112 C.I. 12370
    c) Pigmentrot 3 C.I. 12120
    d) Sudan-Orange 20 C.I. 12055
    e) Pigment Gelb 74 C.I. 11741

vermischt. Dabei wurde ein Gewichtsverhältnis von Pigment zu Silber von 2.5 : 1 eingestellt.

Gießlösung II war eine 7,5%ige Gelatinelösung, die jeweils 0,1% Netzmittel vom Alkylarylsulfonat- und PEO-Alkylether-Typ enthielt.

Durch Auftragung der Gießlösungen I auf eine 100 μ dicke Polyethylenterephthalat-Unterlage und gfs. der Gießlösung II über die Gießlösungen I wurden die folgenden Kontaktfilme hergestellt:

| Film | Gießlösung |
|------|-----------|
| 1 | I a |
| 2 | I b |
| 3 - 7 | I a + II bis I e + II |

In allen Fällen betrug der Silberauftrag 0,6 g/m², der Gelatineauftrag der 2. Schicht (Gießlösung II) 0,9 g/m². Alle Filme wurden wie in der Patentschrift US 4,456,676, Beispiel 1, beschrieben, mit einem Überguß versehen, der als Entwicklersubstanz 3,3,3',3'-Tetramethyl-5,6,5',6'-tetrahydroxy-spiro-bis-indan enthielt.

Nach dem Trocknen der Beschichtungen wurden Proben der erhaltenen Filme im Kontakt durch eine gerasterte Vorlage mit einer Quecksilberdampflampe mit 10 mJ/cm² belichtet. Elemente der Vorlage waren Felder mit 30%, 50% und 70% Rasterpunkten mit einer Rasterweite von 60 Linien/cm..

Die belichteten Filme wurden, wie in US 4,456,676 beschrieben, verarbeitet. Es wurden scharfe Negative der Vorlage mit Tonwerten von 73%, 52% und 32% erhalten.

Proben der erhaltenen Negative wurden zur Hälfte mit einem Klebestreifen abgeklebt und in Ätzlösungen der folgenden Zusammensetzungen getaucht:

|  | Lösung I | Lösung II | Lösung III | Lösung IV |
|--------|----------|-----------|------------|-----------|
| Wasser | 20% | 20% | 20% | 30% |
| Ethanol | 76% | 76% | 60% | 66% |
| Aceton | --- | --- | 16% | --- |
| NaOH | 4% | --- | --- | --- |
| KOH | --- | 4% | 4% | 4% |

Die Temperatur der Lösungen betrug 25¨ C.

Es wurde ein Zeitfächer erstellt, indem Proben 1' (bzw. 0,5), 2' und 3' mit den Ätzlösungen behandelt wurden.

Nach Behandlung der Proben mit den Ätzlösungen wurde durch Abspülen der Proben mit Wasser gestoppt. Anschließend wurden die Proben getrocknet, die Abklebungen wurden entfernt und die Proben auf einen Duplikatfilm umkopiert. Die Tonwerte auf der Kopie in den abgeklebten Bildteilen und den nicht abgeklebten Bildteilen wurden bestimmt und die Differenzen gebildet.

Die Ergebnisse sind in der Tabelle 1 zusammengestellt, wobei der Mittelwert der Tonwertveränderungen (Δ) an den 73%, 52% und 32% Punkten angegeben ist. Striche in der Tabelle kennzeichnen den Fall, daß keine kopierfähige Dichte mehr vorhanden war.

5

Tabelle 1

| Tonwertänderung Δ in % durch Einwirkung der Ätzlösungen | | | | | |
|---|---|---|---|---|---|
| Film | Zeit | Ätzlösung | | | |
| | | I | II | III | IV |
| 1 | 1' | 2 | 2 | --- | keine |
| | 2' | --- | --- | --- | 2 |
| | 3' | --- | --- | --- | --- |
| 2 | 1' | keine | keine | 2 | keine |
| | 2' | --- | --- | --- | 2 |
| | 3' | --- | --- | --- | --- |
| 3 | 1' | 2 | 2 | 3 | keine |
| | 2' | 3 | 3 | 4 | 2 |
| | 3' | 4 | 4 | 6 | 4 |
| 4 | 1' | 2 | 2 | 4 | 2 |
| | 2' | 4 | 4 | 5 | 2 |
| | 3' | 5 | 5 | 7 | 4 |
| 5 | 1' | 3 | 3 | 6 | 2 |
| | 2' | 5 | 6 | --- | 5 |
| | 3' | --- | --- | --- | 5 |
| 6 | 0,5' | 2 | 2 | 5 | keine |
| | 1' | 5 | 5 | --- | 3 |
| | 2' | --- | --- | --- | 5 |
| 7 | 1' | keine | keine | 2 | keine |
| | 2' | keine | keine | 3 | keine |
| | 3' | keine | keine | 4 | keine |

Vergleicht man die Ergebnisse der Versuche mit den Filme 1 und 2 mit denen der anderen Versuche, so erkennt man, daß ohne eine über der pigmentierten Schicht angeordneten Deckschicht die Rasterpunkte nicht die erforderliche Ätzreserve besitzen, und schon nach kurzer Behandlung mit der Ätzlösung keine kopierfähige Dichte mehr vorhanden ist. Mit einer Deckschicht dagegen besteht die Möglichkeit der Rasterpunktverkleinerung ohne Reduzierung der optischen Dichte. Film 7 enthält ein Pigment vom Acetessigestertyp. Da enolische Hydroxygruppen eine geringere Säurestärke aufweisen als phenolische, die in den anderen verwendeten Pigmenten vorliegen, ist es verständlich, daß unter den gleichen Bedingungen wie für Naphthol-azo-Pigmente die Ätzwirkung beim Pigment yellow 74 geringer ist. Durch Variation der Ätzlösung kann aber auch bei diesem Pigment die Ätzwirkung gesteigert werden, wie bei der Anwendung der Ätzlösung III gezeigt wird.

Beispiel 2

Eine chemisch und spektral sensibilisierte Silberhalogenidemulsion $Cl^-:Br^-$ = 70 : 30), die 80 g Gelatine pro Mol Silber enthielt, wurde mit einer wäßrigen Dispersion von Pigmentrot 112 versetzt, so daß auf ein Gewichtsteil Silber 1.5 Gewichtsteile Pigment enthalten waren.

Eine zweite Gießlösung entsprach der Gießlösung II. in Beispiel 1.

Durch Auftragen der beiden Gießlösungen im Zweischichtgießverfahren auf eine 100 µ Polyethylenterephthalat-Unterlage mit einem Emulsionsauftrag von 1.1 g $Ag/m^2$ und einem Gelatineauftrag in der darüberliegenden Schicht aus Gießlösung II von 0,9 $g/m^2$ wurde ein kameraempfindlicher Film hergestellt. Dieser wurde wie in Beispiel 1 beschrieben, mit einem Überguß begossen, der den dortgenannten Entwickler enthielt. Proben dieses Films wurden durch ein Kohinoor-Raster für Linefilm so belichtet, daß 50% bis 70% Rasterflächen auf dem Film erzeugt wurden. Die Proben wurden, wie in Beispiel 1 beschrieben, entwickelt. Es wurden Rastertöne von hoher Punktschärfe erhalten. Aus den erhaltenen Rasternegativen wurden Proben geschnitten, die zur Hälfte abgeklebt wurden. Die so vorbereiteten Proben wurden in der Ätzlösung III aus Beispiel 1, wie dort beschrieben, geätzt und umkopiert. Die Tonwertunterschiede auf der Kopie zwischen abgeklebten und nicht abgeklebten Bildteilen betrugen im Durchschnitt 28% nach 3 Minuten Ätzzeit.

**Ansprüche**

1. System zur Herstellung punktgeätzter lithographischer Filme, bestehend aus einem lichtempfindlichen Material für die Gerbentwicklung und einer Ätzlösung, wobei das lichtempfindliche Material, bestehend aus

a) einem Schichtträger,

b) mindestens einer nicht oder nur wenig gehärteten, mindestens ein Pigment oder einen Farbstoff enthaltenden, gelatinehaltigen Schicht,

c) einer unmittelbar über der unter b) genannten Schicht angeordneten gerbbaren, gelatinehaltigen Deckschicht, die im einfachsten Fall im wesentlichen frei von Zusatzstoffen ist,

d) gegebenenfalls weiteren Hilfsschichten,

e) lichtempfindlichem Silberhalogenid, enthalten in mindestens einer der unter b) und c) genannten Schichten,

nach der bildmäßigen Belichtung, der Entwicklung und dem Entfernen der unbelichteten Bereiche zur Verkleinerung der Rasterpunkte mit der Ätzlösung behandelt wird, dadurch gekennzeichnet, daß

1. die verwendeten Pigmente oder Farbstoffe mindestens eine saure Gruppe enthalten, beständig gegenüber den Verarbeitungsbädern sind und mit Basen in organischen Lösungsmitteln lösliche Salze bilden und

2. die wäßrige Ätzlösung mindestens eine das Pigment oder den Farbstoff ionisierende Base und mindestens ein organisches Lösungsmittel für die gebildeten Ionenpaare enthält.

2. System nach Anspruch 1 dadurch gekennzeichnet, daß die verwendeten Pigmente oder Farbstoffe Dissoziationskonstanten zwischen $10^{-10}$ und $10^{-14}$ aufweisen.

3. System nach Anspruch 1 dadurch gekennzeichnet, daß die verwendeten Pigmente oder Farbstoffe mindestens eine phenolische oder enolische Hydroxygruppe enthalten.

4. System nach Anspruch 1 dadurch gekennzeichnet, daß die in der Ätzlösung verwendeten Basen aus der Gruppe der Alkalihydroxide stammen.

5. System nach Anspruch 1 dadurch gekennzeichnet, daß die in der Ätzlösung verwendeten organischen Lösungsmittel polare, mit Wasser mischbare Lösungsmittel sind.